# EUROPEAN PATENT APPLICATION

(11) **EP 2 128 907 A1**
(43) Date of publication of application: **02.12.2009**
(21) Application number: 08721817.8
(22) Date of filing: 11.03.2008
(51) Int. Cl.: H01L 35/30, H01L 35/32, H02N 11/00

(54) **SUBSTRATE FOR THERMOELECTRIC CONVERSION MODULE, AND THERMOELECTRIC CONVERSION MODULE**

(30) Priority: 13.03.2007 JP 2007063870
(71) Applicant: Sumitomo Chemical Company, Limited, Tokyo 104-8260 (JP)
(72) Inventor: HIROYAMA, Yuichi, Tsukuba-shi Ibaraki 300-2617 (JP); UCHIDA, Yoshio, Moriya-shi Ibaraki 302-0115 (JP)
(74) Representative: Hart-Davis, Jason
(86) International application number: PCT/JP2008/054401
(87) International publication number: WO 2008/111587

(57) **Abstract**

A substrate 1 for thermoelectric conversion module comprises a ceramic material as a principal component and has flexibility. Moreover, a thermoelectric conversion module 2 includes, on at least one side of the substrate 1 for thermoelectric conversion module, a plurality of thermoelectric elements 3, 4 provided so that a longitudinal direction of the thermoelectric elements 3, 4 is along a width direction of the substrate 1, and they are provided side by side in a longitudinal direction of the substrate 1, and electrodes 5 provided at ends of the plurality of thermoelectric elements 3, 4 for electrically connecting the thermoelectric elements 3, 4 in series.

## Description

### Technical Field

The present invention relates to a substrate for thermoelectric conversion module, and a thermoelectric conversion module.

### Background Art

As a conventional type of thermoelectric conversion module, there is known a thermoelectric conversion module provided with a thermoelectric base material including a belt-like base material having flexibility and insulation properties, and thermoelectric elements that are formed of a thin film or the like on the base material so that p-type thermoelectric conversion materials and n-type thermoelectric conversion materials are electrically connected in series alternately in an extending direction of the base material and also so that these thermoelectric conversion materials are thermally connected in parallel in a width direction of the base material (for example, see Patent Document 1).
Patent Document 1 JP 2006-086510 A

### Disclosure of the Invention

### Problems to be solved by the Invention

A thermoelectric conversion module, when used as a power generator, is required to have the capability of being installed even at a place where temperature becomes high so that heat sources, such as the exhaust heat from an engine of an automobile, or an incinerator, can be efficiently used, and also required to have the degree of freedom of shape in accordance with a place for installation.

The thermoelectric conversion module described in the above Patent Document 1 is difficult to be installed at places of high temperature (e.g., temperature of about 250°C or higher) although it has the degree of freedom of shape.

Then, the present invention has been made in view of such circumstances, and has an object to provide a substrate for thermoelectric conversion module and a thermoelectric conversion module having the degree of freedom of shape and also capable of being installed at places of high temperature.

### Means for Solving the Problems

A substrate for thermoelectric conversion module according to the present invention includes a ceramic material as a principal component and has flexibility.

The substrate for thermoelectric conversion module of the present invention has flexibility, and therefore can be, for example, bent, curved, or rolled, and can be transformed into various shapes easily. Further, since the substrate includes a ceramic material as a principal component, the substrate can be used at temperatures higher than a temperature at which a resin film melts. Therefore, the substrate has the degree of freedom of shape and can be used at places of high temperature. Note that, "includes a ceramic material as a principal component" means that the weight percentage of a ceramic material in all the constituent materials of a substrate is the maximum, and the weight percentage thereof is preferably 65 % by weight or higher.

In the substrate for thermoelectric conversion module of the present invention, the ceramic material is preferably a woven or non-woven fabric of ceramic fibers. This allows the substrate to be transformed into various shapes more easily.

In the substrate for thermoelectric conversion module of the present invention, the ceramic material preferably includes ceramic powder and an organic binder. This allows the substrate to be transformed into various shapes easily. Further heating decomposes and removes the organic binder and sinters the ceramic powder, so that the substrate can retain a predetermined shape.

In the substrate for thermoelectric conversion module of the present invention, the ceramic material preferably includes one or more oxides selected from the group consisting of silicon oxide, calcium oxide, aluminium oxide, magnesium oxide, zirconium oxide, and cerium oxide. Use of such an oxide improves the insulation property and heat resistance of the substrate further.

In the substrate for thermoelectric conversion module of the present invention, the organic binder preferably includes one or more resins selected from the group consisting of a cellulose-based resin, a vinyl-based resin, a polyester-based resin, a polyamide-based resin, a polyurethane-based resin, and an acrylic resin. Use of such a resin improves the flexibility of the substrate further.

A thermoelectric conversion module of the present invention includes, on at least one side of the above-described substrate for thermoelectric conversion module, a plurality of thermoelectric elements provided so that a longitudinal direction of the thermoelectric elements is along a width direction of the substrate, and they are spaced from each other in a longitudinal direction of the substrate, and electrodes provided at ends of the plurality of thermoelectric elements for electrically connecting the thermoelectric elements in series.

According to the thermoelectric conversion module of the present invention, a plurality of thermoelectric elements is provided on at least one side of the substrate so that the longitudinal direction of each of the thermoelectric elements may be along the width direction of the substrate and also so that they may be spaced from each other in the longitudinal direction of the substrate. Therefore, in the longitudinal direction of the substrate, the substrate can be, for example, bent, curved, or rolled and can be transformed into various shapes easily. Furthermore, at the ends of the thermoelectric elements, there are provided electrodes for electrically connecting the thermoelectric elements in series. Thus, since an output power in accordance with the number of arrangement of thermoelectric elements can be obtained, the magnitude of electromotive force or the like can be adjusted easily.

In the thermoelectric conversion module of the present invention, the plurality of thermoelectric elements may include p-type thermoelectric elements and n-type thermoelectric elements, wherein the p-type thermoelectric elements and the n-type thermoelectric elements may be provided alternately in the longitudinal direction of the substrate. Alternatively, the plurality of thermoelectric elements may include either of the p-type thermoelectric elements and the n-type thermoelectric elements.

In the thermoelectric conversion module of the present invention, the thermoelectric element preferably includes one or more compounds selected from the group consisting of a mixed metal oxide, silicide, skutterudite, a clathrate compound, a boron compound, and a Te-containing alloy. This makes it possible to use a heat source or the like of relatively high temperature (e.g., 400 to 800°C) when the thermoelectric conversion module is used as a power generator.

Moreover, the thermoelectric conversion module of the present invention preferably further includes a container for accommodating the substrate for thermoelectric conversion module, the module having the thermoelectric elements arranged therein. This can increase the reliability of the module further.

### Effects of the Invention

According to the present invention, it is possible to provide a substrate for thermoelectric conversion module and a thermoelectric conversion module having the degree of freedom of shape and being capable of being installed at places of high temperature.

### Brief Description of the Drawings

FIG 1 is a perspective view illustrating an appearance of a substrate for thermoelectric conversion module according to an embodiment of the present invention.
FIG 2 is a perspective view illustrating an appearance of a thermoelectric conversion module according to an embodiment of the present invention.
FIG 3 is a perspective view illustrating a manufacturing process of a thermoelectric conversion module according to an embodiment of the present invention.
FIG 4 is a perspective view illustrating an alternative manufacturing process of a thermoelectric conversion module according to an embodiment of the present invention.
FIG. 5 is a perspective view illustrating an appearance of a thermoelectric conversion module according to another embodiment of the present invention.
FIG 6 is a perspective view illustrating an appearance of a thermoelectric conversion module according to a still another embodiment of the present invention.

### Description of the Reference Symbols

1 substrate for thermoelectric conversion module
2 thermoelectric conversion module
3 p-type thermoelectric element
4 n-type thermoelectric element
5, 8, 9 electrode
6, 7 I/O electrode

### Best Modes for Carrying Out the Invention

The findings from the present invention can be easily understood by considering the following detailed description with reference to the accompanying drawings illustrated by way of example only. Now, embodiments of the present invention will be described with reference to the accompanying drawings. If possible, the same reference numeral is given to the same element to omit the duplicated description.

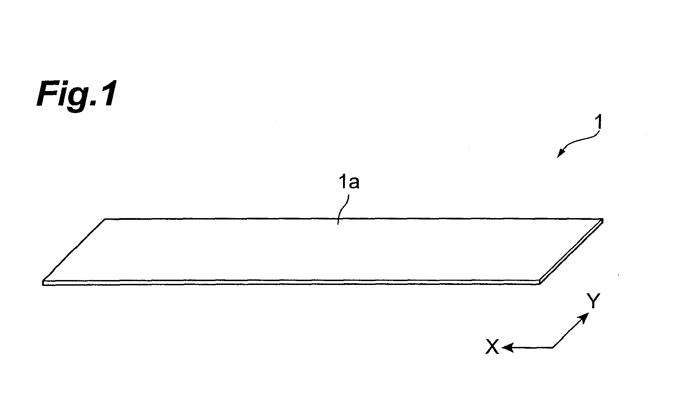

As shown in FIG 1, a substrate 1 for thermoelectric conversion module (hereinafter, may be referred to as a "substrate 1") of an embodiment of the present invention is in the form of a sheet extending in a predetermined direction and is for arranging a plurality of thermoelectric elements to be described later above at least one side 1a thereof. The length in a longitudinal direction (x direction) and the length in a width direction (y direction) are appropriately determined in accordance with an output (e.g., electromotive force) of a target thermoelectric conversion module, i.e., in accordance with the number of arrangement of thermoelectric elements, although not limited in particular. For example, the width is about 1 to 5 cm and the length is about 5 to 50 cm. Usually, a long sheet of 10 to 100 m is appropriately cut and used. The thickness of the substrate 1 is preferably 0.5 to 5 mm, and is particular preferably 1 to 3 mm. The substrate with the thickness less than 0.5 mm tends to lack the strength, while if the thickness exceeds 5 mm, the flexibility tends to decrease.

The substrate 1 according to this embodiment includes a ceramic material as a principal component and is flexible. Specifically, the substrate 1 preferably comprises a mixed material including ceramic powder and an organic binder. As the ceramic powder, highly insulative oxides to be sintered at a predetermined temperature are preferable, and examples thereof include silicon oxide, calcium oxide, aluminium oxide, magnesium oxide, zirconium oxide, cerium oxide, mullite, and cordierite. Among these oxides, in light of low thermal conductivity, the ceramic powder is preferably zirconium oxide, cerium oxide, or mullite. These oxides are used individually or in combination with another or more. Moreover, the ceramic powder may include a glass frit, as needed.

As the organic binder, the ones binding the above-described ceramic powder are preferable, and the examples thereof include a cellulose-based resin, a vinyl-based resin, a polyester-based resin, a polyamide-based resin, a polyurethane-based resin, and an acrylic resin. Among these resins, in light of the moldability and resolvability, the organic binder is preferably a cellulose-based resin, a vinyl-based resin, or an acrylic resin. These resins are used individually or in combination with another or more. The organic binder may include plasticizer, such as phthalic ester or dibutyl phthalate, as needed.

The content ratio of the organic binder is preferably 10 to 30 parts by weight per 100 parts by weight of ceramic powder, and is particularly preferably 15 to 25 parts by weight. With the content ratio less than 10 parts by weight, the flexibility of the substrate tends to decrease, while if the content ratio exceeds 30 parts by weight, the sinterability tends to decrease when the substrate is sintered and used.

The substrate 1 preferably has high electrical insulation property, i.e., high thermal insulation property. When one end of the substrate 1 is exposed to a relatively hot portion and the other end is exposed to a relatively cold portion, the temperature gradient from one end of the substrate 1 to the other end will decrease if the thermal insulation property of the substrate 1 is low. Then, a heat from the outside transfers from the substrate 1 to a thermoelectric element mounted thereon, so that the temperature gradient of the thermoelectric element also decreases. As a result, the temperature difference between both ends of the thermoelectric element decreases, and the obtained output decreases. For this reason, the substrate 1 preferably has such insulation property (i.e., resistivity greater than 10² Ωm) that does not affect the temperature gradient of the thermoelectric element.

Next, a method of manufacturing the substrate for thermoelectric conversion module of this embodiment is described. First, a ceramic powder and an organic vehicle are transferred into a ball mill, and these are mixed and kneaded for a predetermined time to prepare ceramic paste. As the ceramic powder, an oxide particle having an average particle of about 0.1 to 10 µm is preferably used. With the average particle diameter less than 0.1 µm, the viscosity of the ceramic paste tends to increase and the thickness of a sheet in a sheet forming to be described later tends to be nonuniform. When the average particle diameter exceeds 10 µm, the flexibility of the substrate tends to decrease. The organic vehicle includes a resin serving as an organic binder, and solvent. Examples of the resin include a cellulose-based resin such as ethyl cellulose, a vinyl-based resin such as polyvinyl butyral, a polyester-based resin, a polyamide-based resin, a polyurethane-based resin, and an acrylic resin. These resins are used individually or in combination with another or more. Examples of the solvent include organic solvents, such as terpineol, butyl carbitol, acetone, toluene, xylene, ethanol, or methyl ethyl ketone. These solvents are used individually or in combination with another or more.

The blending ratio of the resin is preferably 10 to 30 parts by weight per 100 parts by weight of the ceramic powder, and is particularly preferably 15 to 25 parts by weight. With the blending ratio less than 10 parts by weight, the strength of the substrate tends to decrease, while if the blending ratio exceeds 30 parts by weight, the sinterability tends to decrease when the substrate is sintered and used. The blending ratio of the solvent is preferably 100 to 500 parts by weight per 100 parts by weight of the ceramic powder, and is particularly preferably 150 to 300 parts by weight. With the blending ratio less than 100 parts by weight, the dispersibility of the ceramic powder or resin in the ceramic paste tends to decrease, while the blending ratio exceeding 500 parts by weight tends to pose a problem in terms of the manufacturing cost.

In addition to the above-described ones, about 0.5 to 8 parts by weight of plasticizer, such as phthalate ester or dibutyl phthalate, a dispersing agent, a glass frit, insulator, or the like, per 100 parts by weight of the ceramic powder may be added into the ceramic paste.

Next, the above-described ceramic material paste is applied onto a carrier film, such as a PET (polyethylene terephthalate) film, using a thick film forming technique, such as a doctor blade method, and then is dried at about 130 to 200°C to remove the solvent. In this manner, a ceramic green sheet in the form of a sheet having a thickness of about 0.5 to 5 mm per layer can be formed. Then, the substrate 1 for thermoelectric conversion module having a thickness of about 0.5 to 5 mm can be prepared by laminating one, or two or more ceramic green sheets.

Since the substrate 1 for thermoelectric conversion module according to this embodiment is flexible, the substrate can be, for example, bent, curved, or rolled, and can be transformed into various shapes easily. Then, this substrate can be used at temperatures higher than a temperature at which a resin film melts because it includes a ceramic material as a principal component. Therefore, this substrate has the degree of freedom of shape and can be used at places of high temperature.

Moreover, the substrate 1 for thermoelectric conversion module according to this embodiment is a composite material of ceramic powder including oxides and an organic binder. Therefore, when this substrate 1 is heated, the organic binder is firstly decomposed and removed, and when the heating temperature is increased further, the sintering of ceramic particles starts, resulting into a sintered body of the ceramic material. Accordingly, the ceramic material can retain a bent, curved or rolled shape as described above.

For the substrate 1, the ceramic material may be formed from a woven or non-woven fabric of ceramic fibers. This woven or non-woven fabric of ceramic fibers includes, for example, aluminium oxide and silicon oxide, and is flexible even at high temperatures of about 900°C. As the ceramic fiber, the ones having the diameter of about 7 to 10 µm are available. The thickness of the woven or non-woven fabric of ceramic fibers is about 0.5 to 3 mm. Note that this woven or non-woven fabric may include ceramic powder or a sinter inhibiting material, as needed.

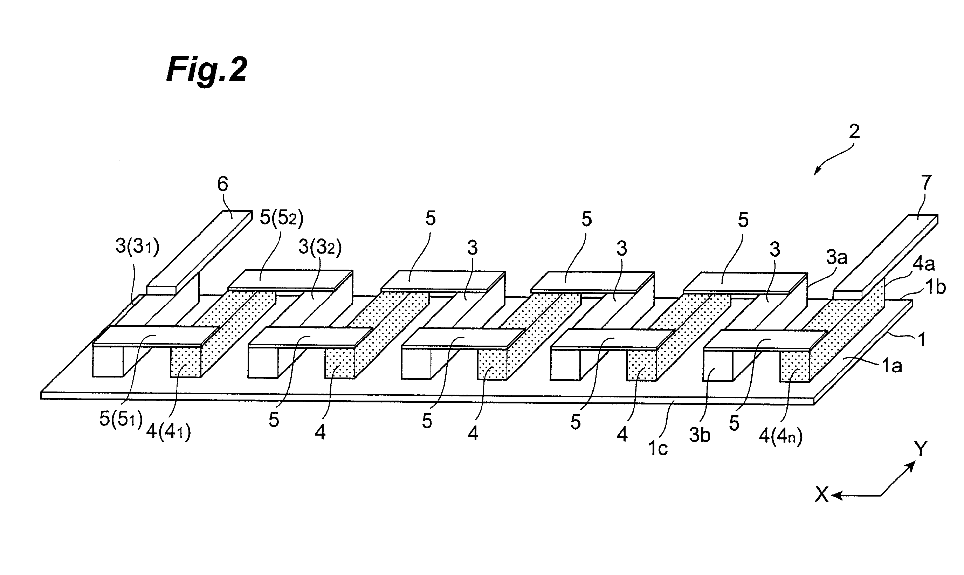

Subsequently, a thermoelectric conversion module according to an embodiment of the present invention is described. As shown in FIG 2, a thermoelectric conversion module 2 of this embodiment includes, on one side 1a of the substrate 1, a plurality of p-type thermoelectric elements 3 and a plurality of n-type thermoelectric elements 4 provided so that a longitudinal direction (y direction) of the plurality of p-type thermoelectric elements 3 and plurality of n-type thermoelectric elements 4 may be along a width direction (y direction) of the substrate 1 and also so that they may be spaced from each other in a longitudinal direction (x direction) of the substrate 1.

The p-type thermoelectric elements 3 and n-type thermoelectric elements 4 (hereinafter, may be referred to as "thermoelectric elements 3, 4) are bar members with a rectangular cross section, and, for example, are fixed onto the substrate 1 with an inorganic adhesive or the like. Examples of the p-type thermoelectric element 3 include mixed metal oxides, such as Ca₃Co₄O₉ or NaₓCoO₂, silicides, such as MnSi_{1.73}, Fe₁₋ₓMnₓSi₂, Si_{0.8}Ge_{0.2}, or β-FeSi₂, skutterudites, such as CoSb₃, FeSb₃, or RFe₃CoSb₁₂ (R represents La, Ce, or Yb), and Te-containing alloys, such as BiTeSb, or PbTeSb. Examples of the n-type thermoelectric element 4 include mixed metal oxides, such as SrTiO₃, Zn₁₋ₓAlₓO, CaMnO₃, LaNiO₃, BaₓTi₈O₁₆, or Ti₁₋ₓNbₓO, silicides, such as Mg₂Si, Fe₁₋ₓCoₓSi₂, Si_{0.8}Ge_{0.2}, or β-FeSi₂, skutterudites, clathrate compounds, such as Ba₈Al₁₂Si₃₀, or Ba₈Al₁₂Ge₃₀, boron compounds, such as CaB₆, SrB₆, BaB₆, or CeB₆, and Te-containing alloys, such as BiTeSb or PbTeSb. Among these, in light of the manufacturing cost and the stability in the atmosphere, thermoelectric elements of a mixed metal oxide are preferable, and a combination of Ca₃Co₄O₉ as the p-type thermoelectric element and CaMnO₃ as the n-type thermoelectric element is particularly preferable. Moreover, these thermoelectric elements can be used suitably for power generators using an especially high temperature heat source because these thermoelectric elements exhibit excellent thermoelectric properties at about 700 to 800°C in particular.

The plurality of p-type thermoelectric elements 3 and plurality of n-type thermoelectric elements 4 alternatively arranged on the substrate 1 are electrically connected in series through tabular electrodes 5. Hereinafter, the thermoelectric conversion module according to this embodiment is specifically described. Note that, one end of an thermoelectric element refer to ends 3a, 4a of the thermoelectric elements corresponding to one end 1b side in the width direction of the substrate 1, while the other end of the thermoelectric element refer to ends 3b, 4b of the thermoelectric elements corresponding to the other end 1c side in the width direction of the substrate 1.

A p-type thermoelectric element 3₁ provided at one end in the longitudinal direction of the substrate 1 has an I/O electrode 6 provided at one end thereof. The P-type thermoelectric element 3₁ is electrically connected to an adjacent n-type thermoelectric element 4₁ through an electrode 5₁ provided from the other end of the p-type thermoelectric element 3₁ to the other end of the n-type thermoelectric element 4₁. The n-type thermoelectric element 4₁ is electrically connected to another adjacent p-type thermoelectric element 3₂ through an electrode 5₂ provided from one end of the n-type thermoelectric element 4₁ to one end of the p-type thermoelectric element 3₂. Then, an electrical connection between each of the thermoelectric elements 3 and each of the thermoelectric elements 4 is repeated by bonding the electrode 5 at one ends of the adjacent thermoelectric elements 3, 4. Furthermore, an n-type thermoelectric element 4ₙ provided at the other end in the longitudinal direction of the substrate 1 has an I/O electrode 7 provided at one end thereof. As a result, each of the thermoelectric elements 3, 4 is electrically connected in series between the I/O electrode 6 and the I/O electrode 7.

In this embodiment, the plurality of p-type thermoelectric elements 3 and the plurality of n-type thermoelectric elements 4 are alternately spaced in the longitudinal direction, however, only either of the p-type thermoelectric elements or the n-type thermoelectric elements may be arranged. In this case, the electrical connection of the thermoelectric elements in series can be made, for example, by electrically connecting one end of a p-type thermoelectric element to the other end of an adjacent p-type thermoelectric element through an electrode. The plurality of thermoelectric elements 3, 4 may be provided in both sides of the substrate 1.

In the thermoelectric conversion module 2, an electromotive force can be generated at each of the I/O electrodes 6, 7 by making one end 1b side in the width direction of the substrate 1 relatively hotter and making the other end 1c side relatively colder. One end 1b side in the width direction of the substrate 1 can be made relatively hotter or colder and the other end 1c side can be made relatively colder or hotter by applying a voltage to each of the I/O electrodes 6, 7. The number of arrangement of the p-type thermoelectric elements 3 and n-type thermoelectric elements 4 is appropriately determined in accordance with the purpose of use of a thermoelectric converter because the electromotive force or the temperature difference can be adjusted by increasing or decreasing this number of arrangement.

Metal or an alloy can be used as the material of the electrode 5. Examples of the material on the relatively hotter side of the thermoelectric conversion module 2 include metals, such as Zr, Au, Ag, Pt, Pd, Cu, Ti, Ni, Mo, Zn, W, or V, and an alloy of each of these metals and another or more. On the other hand, examples of the material on the relatively colder side include metals, such as Bi, Sn, Ag, Cu, Pt, Al, Au, Fe, Mo, Zn, or Pb, or an alloy each of these metals and another or more. Electrodes using these materials can be used suitably for power generators using an especially high temperature heat source because these electrodes can improve heat resistance, corrosion resistance, and the adhesiveness to the thermoelectric element.

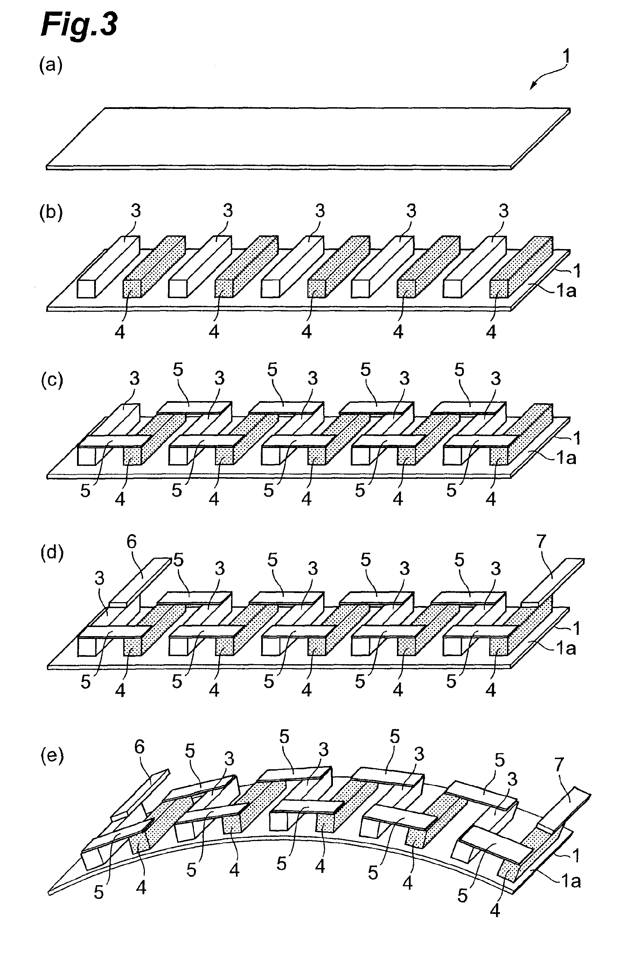

Subsequently, a manufacturing method of the thermoelectric conversion module of this embodiment is described. As shown in FIG 3, first, the substrate 1 is formed according to the above-described procedure (a). Next, on one side 1a of the substrate 1, a predetermined number of p-type thermoelectric elements 3 and n-type thermoelectric elements 4 are arranged so that the longitudinal direction of each of the thermoelectric elements 3, 4 may be along the width direction of the substrate 1 and also so that the predetermined number of p-type thermoelectric elements 3 and n-type thermoelectric elements 4 may be spaced from each other in the longitudinal direction of the substrate 1 (b). At this time, each of the thermoelectric elements is fixed to the substrate 1 using an inorganic adhesive or the like. Then, the tabular electrode 5 is bonded to a predetermined position in the surface corresponding to the surface to be bonded to the substrate 1 in each of the thermoelectric elements, using an inorganic adhesive or the like (c). Furthermore, each of the I/O electrodes 6, 7 is bonded to each of the thermoelectric elements at both ends in the longitudinal direction of the substrate 1, using an inorganic adhesive or the like (d). Thus, the thermoelectric conversion module 2 capable of being transformed into a predetermined shape can be prepared. The thermoelectric conversion module 2 can also retain a predetermined shape by being heated to a predetermined temperature (e).

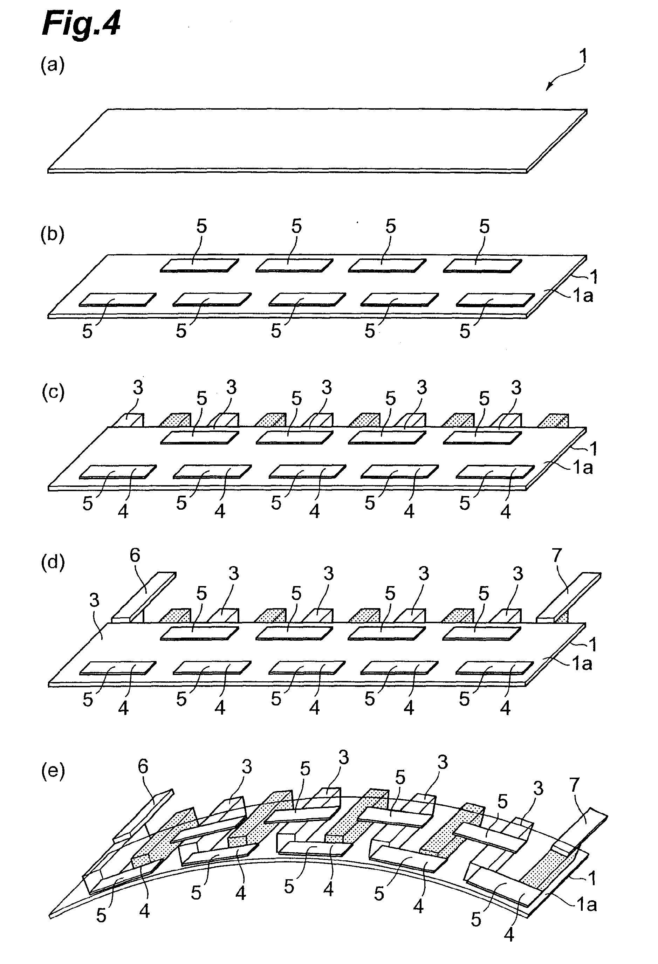

As shown in FIG 4, the electrode 5 may be formed on the substrate 1 in advance. Namely, first, the substrate 1 is formed (a), and the electrode 5 is provided at a predetermined position on one side 1a of the substrate 1 (b). Then, each of the thermoelectric elements 3, 4 is arranged at a position where each of the thermoelectric elements 3, 4 is electrically connected in series (c), and each of the I/O electrodes 6, 7 may be provided in each of the thermoelectric element 3₁, 4ₙ at both ends in the longitudinal direction of the substrate 1 (d). Thus, the thermoelectric conversion module 2 capable of being transformed into a predetermined shape can be prepared. The thermoelectric conversion module 2 can also retain a predetermined shape by being heated to a predetermined temperature (e). The electrode 5 can be formed on the substrate 1 using a thin film technology, such as sputtering or vapor deposition, or using screen printing, plating, or the like. The thermoelectric element may be formed by a thin film technology, such as sputtering or vapor deposition, or by screen printing of a paste obtained by adding an organic vehicle into the above-described thermoelectric material.

In the thermoelectric conversion module 2 according to this embodiment, the plurality of thermoelectric elements 3, 4 is provided on at least one side 1a of the substrate 1 so that the longitudinal direction of each of the plurality of thermoelectric elements 3, 4 may be along the width direction of the substrate 1 and also so that the plurality of thermoelectric elements 3, 4 may be spaced from each other in the longitudinal direction. For this reason, in the longitudinal direction of the substrate, the substrate can be, for example, bent, curved, or rolled and can be transformed into various shapes easily. Furthermore, the electrode 5 for electrically connecting the plurality of thermoelectric element 3, 4 in series is provided at the ends of the plurality of thermoelectric elements 3, 4. The magnitude of electromotive force or the like can be adjusted easily because an output power in accordance with the number of arrangement of thermoelectric elements 3, 4 can be obtained.

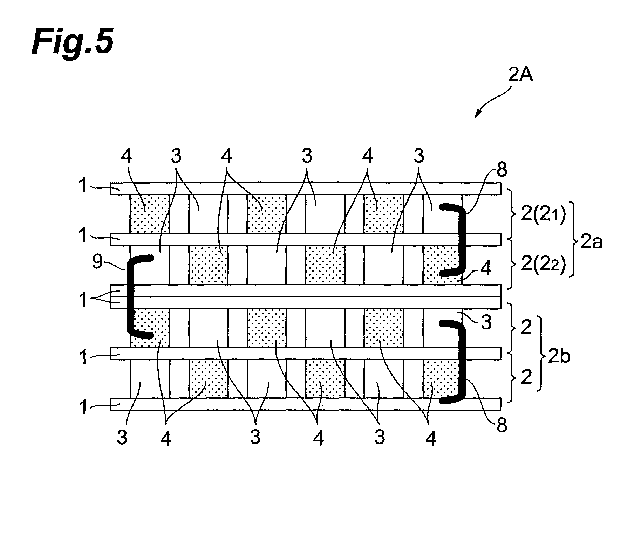

A thermoelectric conversion module according to a secondary embodiment is described. As shown in FIG 5, a thermoelectric conversion module 2A according to the secondary embodiment is a stacked module including two or more thermoelectric conversion modules 2 described above. Namely, two thermoelectric conversion modules 2₁, 2₂ are bonded together so that the sides where each of the thermoelectric elements 3, 4 is formed may face to each other and also so that the substrate 1 for thermoelectric conversion module may be interposed between the thermoelectric conversion module 2₁ and the thermoelectric conversion module 2₂, thereby forming one unit of stacked module 2a. Then, in the stacked module 2a, all the thermoelectric elements 3, 4 of the stacked module 2a are electrically connected in series by connecting the thermoelectric conversion module 2₁ to the thermoelectric conversion modules 2₂ through the electrode 8 at one end in the longitudinal direction. Furthermore, a thermoelectric conversion module 2A, in which all the thermoelectric elements 3, 4 are electrically connected in series, is formed by bonding another stacked module 2b of the same configuration as that of the stacked module 2a to the stacked module 2a and connecting the stacked modules 2a to the stacked modules 2b through an electrode 9 at the other end in the longitudinal direction.

According to this another embodiment, the strength of the thermoelectric conversion module 2A can be improved and the density of thermoelectric elements can be increased because the thermoelectric conversion module 2A has a stacked structure.

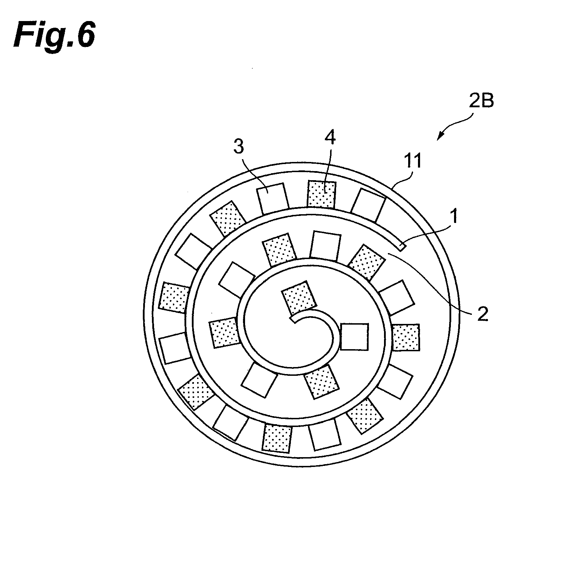

A thermoelectric conversion module according to a still another embodiment is described. As shown in FIG 6, a thermoelectric conversion module 2B according to this embodiment comprises the substrate 1 (thermoelectric conversion module 2) having the thermoelectric elements 3, 4 mounted thereon, a container 11 of a predetermined shape (e.g., cylindrical), wherein the substrate 1 is transformed (e.g., rolled) as needed and is accommodated in the container 11. Heat-resistant alloys, such as a nickel-base alloy (e.g., Hastelloy, Inconel (both are the registered trademarks)) and a stainless steel (e.g., SUS304, SUS316), the above-described ceramic materials used in the substrate 1, or the like can be used as the material of the container 11. When the ceramic material used in the substrate 1 is used, a resin may be included therein as needed.

According to the still another embodiment, the strength of the thermoelectric conversion module 2B can be improved further because the substrate 1 having the thermoelectric elements 3, 4 mounted thereon is accommodated in the container 11. Moreover, the thermoelectric conversion module 2B can be used at relatively high temperatures because the container 11 is heat resistant.

In the foregoing paragraphs, the preferred embodiments of the present invention have been described, however, the present invention is not limited to the above-described embodiments.

## Claims

1. A substrate for thermoelectric conversion module, comprising a ceramic material as a principal component and having flexibility.

2. The substrate for thermoelectric conversion module according to claim 1, wherein the ceramic material is a woven or non-woven fabric of ceramic fibers.

3. The substrate for thermoelectric conversion module according to claim 1, wherein the ceramic material includes ceramic powder and an organic binder.

4. The substrate for thermoelectric conversion module according to any one of claims 1 to 3, wherein the ceramic material includes one or more oxides selected from the group consisting of silicon oxide, calcium oxide, aluminium oxide, magnesium oxide, zirconium oxide, cerium oxide, mullite, and cordierite.

5. The substrate for thermoelectric conversion module according to claim 3 or 4, wherein the organic binder includes one or more resins selected from the group consisting of a cellulose-based resin, a vinyl-based resin, a polyester-based resin, a polyamide-based resin, a polyurethane-based resin, and an acrylic resin.

6. A thermoelectric conversion module, comprising, on at least one side of a substrate for thermoelectric conversion module according to any one of claims 1 to 5,
a plurality of thermoelectric elements provided so that a longitudinal direction of the thermoelectric elements is along a width direction of the substrate, and they are spaced from each other in a longitudinal direction of the substrate, and
electrodes provided at ends of the plurality of thermoelectric elements for electrically connecting the thermoelectric elements in series.

7. The thermoelectric conversion module according to claim 6, wherein
the plurality of thermoelectric elements includes a p-type thermoelectric element and an n-type thermoelectric element, and
the p-type thermoelectric elements and the n-type thermoelectric elements are alternately provided in the longitudinal direction of the substrate.

8. The thermoelectric conversion module according to claim 6, wherein
the plurality of thermoelectric elements is p-type thermoelectric elements or n-type thermoelectric elements.

9. The thermoelectric conversion module according to any one of claims 6 to 8, wherein
the thermoelectric element includes one or more compounds selected from the group consisting of a mixed metal oxide, silicide, skutterudite, a clathrate compound, a boron compound, and a Te-containing alloy.

10. The thermoelectric conversion module according to any one of claims 6 to 9, further comprising a container for accommodating the substrate for thermoelectric conversion module, the module having the thermoelectric elements arranged therein.
